## Europäisches Patentamt

## European Patent Office

## Office européen des brevets

(19)

(11) Veröffentlichungsnummer: **0 002 738**
**B1**

(12) **EUROPÄISCHE PATENTSCHRIFT**

(45) Veröffentlichungstag der Patentschrift:
02.09.81

(21) Anmeldenummer: 78101690.2

(22) Anmeldetag: 15.12.78

(51) Int. Cl.³: **C 23 C 13/00,** C 03 C 17/09 //
H05K3/10

(54) **Verfahren zum Aufbringen einer Materialschicht auf eine Oberfläche eines plattenförmigen Werkstücks mittels eines Laserstrahls.**

(30) Priorität: **21.12.77 US 862797**

(43) Veröffentlichungstag der Anmeldung:
**11.07.79 Patentblatt 79/14**

(45) Bekanntmachung des Hinweises auf die Patenterteilung:
**02.09.81 Patentblatt 81/35**

(84) Benannte Vertragsstaaten:
**DE FR GB**

(56) Entgegenhaltungen:
**DE-A-1 521 323**
**DE-A-1 621 306**
**US-A-3 560 258**

(73) Patentinhaber: **International Business Machines Corporation, Armonk, N.Y. 10504 (US)**

(72) Erfinder: **Drew, Roland Francis, 22 Lori Street, Poughkeepsie, N.Y. 12603 (US)**
Erfinder: **Schmidt, Frank John, jr., Cragston, Highland Falls, N.Y. 10928 (US)**
Erfinder: **Vanduynhoven, Thomas Jerome, 27 Russett Road, Poughkeepsie, N.Y. 12601 (US)**

(74) Vertreter: **Willich, Wolfgang, Dipl.-Ing., Schönaicher Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

# Verfahren zum Aufbringen einer Materialschicht auf eine Oberfläche eines plattenförmigen Werkstücks mittels eines Laserstrahls

Die Erfindung betrifft ein Verfahren zum Aufbringen einer Materialschicht in bestimmten Mustern auf eine Oberfläche eines plattenförmigen Werkstücks durch Verdampfen des in einer Ebene benachbart zur Werkstückoberfläche befindlichen Materials mittels eines Laserstrahls.

Laserstrahlen werden als Energiequelle für die unterschiedlichsten Zwecke eingesetzt, z. B. zur Erzeugung von Impulsen einer amplitudenmodulierten kohärenten Strahlung zur Bildung von Löchern in metallischem Werkstoff, etwa zum Zwecke der Herstellung von Faksimile-Abbildungen hoher Auflösung (US-PS 4 000 492). Eine andere Einsatzmöglichkeit ist die Aufzeichnung und Wiedergabe von flächigen Mustern und Darstellungen mittels eines Digital-Lasers, wie in der US-PS 4 001 840 beschrieben.

Die Energie eines Laserstrahls läßt sich aber auch zum Abscheiden von Schichten auf Werkstücke einsetzen; so ist im IBM Technical Disclosure Bulletin, Band 8, Nr. 2, Seite 285 (Juli 1965), eine Anordnung gezeigt, bei der ein Laserstrahl in eine Vakuumkammer gerichtet wird, in welcher in einem gewissen Abstand vor dem zu beschichtenden Werkstück, einem Trägerkörper für eine elektronische Schaltungseinheit, eine dünne Schicht des Beschichtungsmaterials parallel zu der zu beschichtenden Fläche, z. B. auf der Rückseite einer Glasplatte, angeordnet ist. Unter der Wirkung des Laserstrahls verdampft das Material und schlägt sich im Vakuum auf die Werkstückoberfläche nieder.

Bei einer ganz ähnlichen Laserstrahlanordnung gemäß der US-PS 3 560 258 befindet sich das Beschichtungsmaterial gleichfalls vor dem Werkstück in einer evakuierten Kammer, und zwar ist es dort als dünne Schicht auf der Oberfläche einer Glasplatte aufgetragen und in sehr geringem Abstand von der Werkstückfläche angeordnet. Der Laserstrahl tritt somit durch die Glasplatte hindurch und verdampft an denjenigen Stellen, auf welche der Strahl gerichtet wird, das Beschichtungsmaterial zur Bildung eines entsprechenden Musters auf dem Werkstück.

Die bekannten Anordnungen von Verfahren zur Bildung einer Schicht, ggf. in Form eines vorgegebenen Musters, haben verschiedene Nachteile. So ist mit der Anordnung nach der US-PS 3 560 258 eine aufwendige Überwachung der Schichtdicke auf der Basisplatte erforderlich, um die gewünschte Schichtstärke auf dem Substrat zu erzielen. Außerdem ist das dort beschriebene Verfahren teuer; denn die Basisplatte mit dem Materialfilm kann nur einmal verwendet und muß für einen weiteren Beschichtungsvorgang erneuert werden. Schließlich ist auch die Überwachung der Ausrichtung des Musters auf dem Substrat erschwert, weil der auf der Glasplatte befindliche Materialfilm die Sicht auf das Werkstück verdeckt und somit die Beobachtung der Laserstrahlausrichtung verhindert.

Mit dem Verfahren nach der Erfindung wird die Aufgabe gelöst, die Oberfläche eines Werkstücks aus transparentem Werkstoff auf eine kostengünstige und zuverlässige Weise mittels eines Laserstrahls mit einem Material zu beschichten, insbesondere zum Zwecke des Auftragens eines vorgegebenen, durch die Bewegungen des Laserstrahls bestimmten Musters. Das erfindungsgemäße Verfahren ist im Patentanspruch 1 angegeben.

Bei dem aufzutragenden Material handelt es sich vorzugsweise um ein Metall, jedoch eignet sich das Verfahren grundsätzlich auch zur Anwendung beim Auftragen anderer Materialien, welche mittels des Laserstrahls verdampft werden können. Eine bevorzugte Anwendung ist die Bildung von Leiterzügen auf Festkörper-Schaltungssubstraten, zur Bildung von Mustern aus Leitern und Widerständen. Das erfindungsgemäße Verfahren kann aber auch zur Bildung und zur Instandsetzung von metallischen Masken auf Glasplatten eingesetzt werden. Ein besonderer Vorteil des erfindungsgemäßen Verfahrens ist auch, daß es die Möglichkeit bietet, das Beschichtungsmaterial in Form eines Materialblocks oder in einem Schmelztiegel bereitzustellen, so daß eine Vielzahl von Beschichtungen aufeinanderfolgend durchgeführt werden kann.

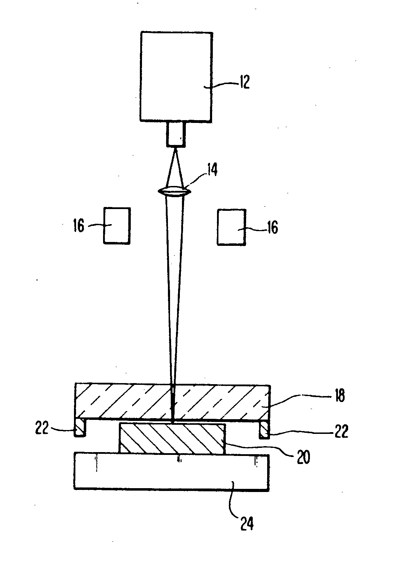

Das erfindungsgemäße Verfahren wird nachfolgend im einzelnen erläutert. Hierzu ist in der Zeichnung eine Laserstrahlanordnung zur Beschichtung eines Werkstücks aus transparentem Werkstoff schematisch dargestellt.

Die in der Zeichnung dargestellte Laserstrahlanordnung besteht aus einer Laserstrahlquelle 12, einer Linse 14 und einem Ablenksystem 16. Zur Beschichtung eines transparenten Werkstücks 18, z. B. eines Substrats, auf der an der Unterseite befindlichen Fläche mit einem vorgegebenen Material ist unmittelbar benachbart zu dieser Fläche ein entsprechender Materialblock 20 angeordnet. Für die Laseranordnung kann beispielsweise ein Festkörperlaser der Bauart Nd³⁺ YAG mit einer Wellenlänge in der Größenordnung von 1,06 μ vorgesehen werden. Die Wellenlänge des Lasers ist jedoch auf die Transparenz-Wellenlänge des Werkstücks 18 abzustimmen.

Das Werkstück 18 ist an seinen Kanten auf einem Rahmen 22 gelagert, und der Materialblock 20 liegt auf einer Trägerplatte 24 auf. Der Abstand zwischen der Fläche an der Unterseite des Werkstücks 18 und der Fläche an der Oberseite des Materialblocks 20 ist sehr gering, nämlich in der Größenordnung von 50 bis 100 μ. Grundsätzlich ist es auch möglich, das Werkstück 18 unmittelbar auf dem Materialblock 20 zu lagern. Für das Ergebnis des mit der dargestellten Anordnung durchzuführenden Beschichtungsverfahrens hat der Abstand zwischen dem Werkstück 18 und dem Materialblock 20 eine maßgebliche Bedeutung; man kann daher die Anordnung auch so gestalten, daß der betreffende Abstand auf unterschiedliche Werte einstellbar ist.

Der Materialblock 20 besteht entweder ausschließlich aus dem für die Beschichtung vorgesehenen Material oder er ist als Behälter gestaltet, der mit dem gewünschten Material gefüllt ist. Zur Beschichtung mittels Laserstrahl haben sich Kupfer, Messing, Chrom und Aluminium als besonders geeignet erwiesen. Das Werkstück 18 ist, wie bereits erwähnt, aus transparentem Werkstoff, welcher sich für die Beschichtung mit Metall eignet. Es kann beispielsweise als Glasplatte ausgebildet sein. Für die Beschichtung des Werkstücks 18 kommen aber auch nicht leitende Materialien in Frage, die entweder als geschlossene Schicht oder in Form eines vorbestimmten Musters aufgetragen werden. Besondere Bedeutung für die Auswahl des Werkstoffs des Werkstücks 18 in Anpassung an die Frequenz des Laserstrahls hat auch die Lichtablenkcharakteristik des für das Werkstück 18 vorgesehenen transparenten Werkstoffs.

In der praktischen Anwendung der dargestellten Anordnung wird auf der unteren Fläche des Werkstücks 18 entsprechend den Vorschubbewegungen des Laserstrahls ein bestimmtes Muster aufgetragen, vorzugsweise aus leitendem Material, wobei die Vorschubbewegungen des Laserstrahls durch das Ablenksystem 16 bestimmt werden. Entsprechend den durch das Ablenksystem 16 erzeugten Bewegungen des Laserstrahls wird an den jeweils vom Strahl getroffenen Positionen des Metallblocks 20 das Material verdampft und auf der zugeordneten Fläche des Werkstücks 18 niedergeschlagen. Hierbei ist eine einheitliche Schichtdicke des Niederschlags erzielbar, und bei entsprechender Auswahl der Materialien des Blocks 20 und des Werkstücks 18 findet eine zuverlässige Adhäsion zwischen Schicht und Trägerfläche statt. Entsprechendes gilt für die Beschichtung mit nichtmetallischen Materialien, z. B. einem keramischen Werkstoff, soweit sich das betreffende Material für die Verdampfung durch den Laserstrahl eignet.

Verwendet man für den Materialblock anstelle eines Blocks einen mit dem betreffenden Material gefüllten Behälter, z. B. einen Schmelztiegel, und erhitzt man das Material auf eine Temperatur knapp über dem Schmelzpunkt, so werden Veränderungen, wie Vertiefungen oder Niederschläge, auf der Behälterwand vermieden, und der Schmelztiegel kann für einen fortlaufenden Beschichtungsprozeß verwendet werden.

Als Beispiel sei angenommen, mit der in der Zeichnung dargestellten Anordnung soll mittels eines YAG-Lasers mit einer Wellenlänge von 1,06 μ auf das als Glasplatte ausgebildete Werkstück eine Kupferschicht aufgetragen werden. Der Materialblock 20 für das Kupfer habe eine Größe von 6 × 6 mm und die Glasplatte eine Kantenlänge von 1,5 mm. Die Impuls-Repetitionsrate des Lasers betrage 3 kHz bei einer durchschnittlichen Leistung von 2 Watt, und die Vorschubgeschwindigkeit des Lasers sei mit 2 mm/s angenommen. Die erzielbare Breite der auf der Werkstückfläche niedergeschlagenen Leiterzüge beträgt sodann 250 μ und weniger bei einheitlicher Dicke der Schicht und guter Adhäsion zwischen Werkstückoberfläche und Kupferschicht.

## Patentansprüche

1. Verfahren zum Aufbringen einer Materialschicht in bestimmten Mustern auf eine Oberfläche eines plattenförmigen Werkstücks durch Verdampfen des in einer Ebene benachbart zur Werkstückoberfläche befindlichen Materials mittels eines Laserstrahls, dadurch gekennzeichnet, daß das Werkstück aus transparentem Werkstoff besteht und daß der entsprechend dem vorgesehenen Muster bewegte Laserstrahl von der entgegengesetzten Werkstückseite auf das Werkstück gerichtet wird.

2. Verfahren nach Anspruch 1, dadurch gekennzeichnet, daß das Material leitend ist.

3. Verfahren nach Anspruch 2, dadurch gekennzeichnet, daß als Material Kupfer verwendet wird.

4. Verfahren nach Anspruch 1, dadurch gekennzeichnet, daß das Werkstück aus Glas besteht.

5. Verfahren nach Anspruch 1, dadurch gekennzeichnet, daß der Laserstrahl mit einer Vorschubgeschwindigkeit von etwa 2 mm/s bewegt wird.

6. Verfahren nach Anspruch 1, dadurch gekennzeichnet, daß ein Laserstrahl von 2 Watt Leistung verwendet wird.

7. Verfahren nach Anspruch 1, dadurch gekennzeichnet, daß der Laserstrahl mit einer Impuls-Repetitionsrate von etwa 3 kHz betrieben wird.

## Claims

1. Method of depositing a material layer in particular patterns upon a surface of a disk-shaped workpiece by vaporizing the material in a plane adjacent to the workpiece surface by means of a laser beam, characterized in that the workpiece consists of transparent material and that the laser beam moved in accordance with the pattern provided is directed to the workpiece from the opposite workpiece side.

2. Method in accordance with claim 1, characterized in that the material is conductive.

3. Method in accordance with claim 2, characterized in that the material used is copper.

4. Method in accordance with claim 1, characterized in that the workpiece consists of glass.

5. Method in accordance with claim 1, characterized in that the laser beam is advanced at a speed of about 2 mm/s.

6. Method in accordance with claim 1, characterized in that a laser beam of 2 watts is used.

7. Method in accordance with claim 1, characterized in that the laser beam is operated at a pulse repetition rate of about 3 kHz.

## Revendications

1. Méthode pour déposer une couche de matériau, dans des configurations données, sur une surface plane d'une pièce en évaporant à l'aide d'un faisceau laser, du matériau se trouvant dans un plan adjacent à la surface de la pièce, caractérisée en ce que la pièce est composée d'un matériau transparent et que le faisceau laser en mouvement selon la configuration désirée est dirigé sur la pièce à partir du côté opposé de la pièce.

2. Méthode selon la revendication 1, caractérisée en ce que le matériau est conducteur.

3. Méthode selon la revendication 2, caractérisé en ce que le matériau utilisé est du cuivre.

4. Méthode selon la revendication 1, caractérisée en ce que la pièce est composée de verre.

5. Méthode selon la revendication 1, caractérisée en ce que le faisceau laser est en mouvement à une vitesse d'environ 2 mm/s.

6. Méthode selon la revendication 1, caractérisée en ce qu'un faisceau laser d'une puissance de 2 watts est utilisé.

7. Méthode selon la revendication 1, caractérisée en ce que le faisceau laser fonctionne à la fréquence de répétition d'impulsions d'environ 3 kHz.